# FASCICULE DE BREVET EUROPEEN

(11) **EP 0 962 980 B1**
(45) Date de publication et mention de la délivrance du brevet: **27.12.2006**
(21) Numéro de dépôt: 99401359.7
(22) Date de dépôt: 04.06.1999
(51) Int. Cl.: H01L 23/66

(54) **Module micro-électronique hyperfréquences comportant deux matériaux de substrat différents et procédé de fabrication d'un tel module**
Mikroelektronisches Hyperfrequenzmodul mit zwei verschiedenen Substratmaterialen und Herstellungsverfahren eines solchen Moduls
Microelectronic hyperfrequency module having two different substrate materials and method of making such module

(30) Priorité: 05.06.1998 FR 9807096
(43) Date de publication de la demande: 08.12.1999
(73) Titulaire: Thales, 75008 Paris (FR)
(72) Inventeur: Mabire, Jacques, 94117 Arcueil Cedex (FR); Bodeveix, Jean-Claude, 94117 Arcueil Cedex (FR)
(74) Mandataire: Guérin, Michel

(56) Documents cités:
- EP-A- 0 197 476
- US-A- 5 745 981
- H. TOMIMURO ET AL.: "Reliability study on microwave integrated circuits for the 20G-D2 transmission systems" REVIEW OF THE ELECTRICAL COMMUNICATION LABORATORIES, vol. 32, no. 6, novembre 1984 (1984-11), pages 1100-1106, XP002093322 tokyo,JP

## Description

La présente invention concerne les modules micro-électroniques hyperfréquences comportant deux matériaux de substrat différents dans une structure d'interconnexion en couche épaisse. L'invention concerne aussi le procédé de fabrication d'un tel module et plus précisément la fabrication du substrat métallisé du module.

Différents documents de l'état de l'art divulguent des modules microélectroniques comportant des substrats de différentes natures.

Le document EP-A-0 197 476 de ANT NACHRICHTENTECH divulgue un module micro-électronique comportant un substrat porteur et un substrat ferrite avec une couche de métal par dessus.

Le document US-A- 5 745 981 de KORMAN CHARLES STEVEN ET AL montre un module comportant un substrat céramique dans lequel est enfoui un substrat ferromagnétique.

Le document de H.TOMIMURO ET AL dans : REVIEW OF THE ELECTRICAL COMMUNICATION LABORATORIES, vol.32, no.6, 1984-11, pages 1100-1106, XP002093322 divulguent un circuit intégré comportant un substrat en alumine et un substrat en ferrite assemblés sur un support métallique

Les modules micro-électroniques modernes permettent de réaliser des fonctions électroniques diverses en associant sur un substrat des composants variés comme des résistances, des condensateurs, des diodes, des transistors, des circuits intégrés hyperfréquences etc. Le substrat peut être de type céramique ou verre et comporte les liaisons électriques et tout ou partie des composants passifs réalisés par exemple par des techniques de couche épaisse.

Dans certaines applications en hyperfréquence, ces modules micro-électroniques utilisent dans une technologie microbande fonctionnant jusqu'à 20 GHz, deux substrats réalisés dans des matériaux différents, généralement un substrat d'alumine (Al₂O₃) de pureté 99.6% et un substrat ferrite.

Le substrat d'alumine (Al₂O₃) reçoit les fonctions de type oscillateur, amplificateur, filtre, le substrat ferrite recevant les fonctions isolateur, circulateur.

Ces deux types de substrat sont manufactures séparément en utilisant des moyens d'usinage laser et sérigraphie couche épaisse pour les fonctions précédemment citées.

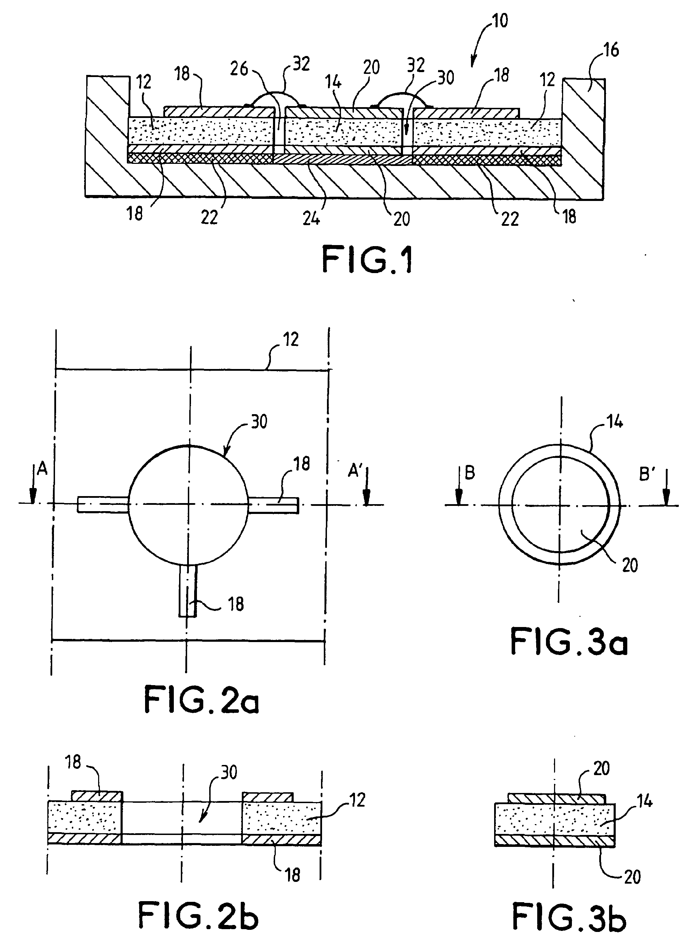

La figure 1 montre un module micro-électronique 10 hyperfréquences selon l'art antérieur comportant deux substrats en matériaux différents, un substrat d'alumine 12 (ou substrat porteur en alumine) et un substrat ferrite 14, intégrés dans un boîtier 16 en titane. Le substrat en alumine 12 comporte des métallisations 18 sur chacune des ses deux faces opposées, et de la même façon le substrat ferrite comporte des métallisations 20. Les métallisations des deux substrats sont réalisées en technologie couche épaisse.

Selon l'art antérieur, dans une première phase, les deux substrats métallisés sont réalisés séparément selon des techniques connues.

La figure 2a montre le substrat en alumine 12 dans lequel est effectué un passage 30 de forme circulaire par découpe au laser CO2 afin de recevoir le substrat ferrite 14 en forme de plaquette circulaire de dimension sensiblement identique à celle du passage 30. Les tolérances de fabrications du passage 30 et du substrat ferrite 14 sont telles que le substrat 14 puisse être inséré dans le passage 30 sans difficulté. La figure 2b représente une vue en coupe, selon un axe AA', montrant le passage 30 du substrat en alumine de la figure 2a.

La figure 3a montre le substrat ferrite 14 comportant les métallisations 20. La figure 3b représente une vue en coupe selon un axe BB' du substrat ferrite de la figure 3a.

Dans une seconde phase de la fabrication du module, on effectue l'intégration du substrat en alumine 12 métallisé et du substrat ferrite 14 métallisé dans le boîtier 16 du module micro-électronique 10 représenté à la figure 1. Cette intégration comporte au moins les opérations suivantes.
- collage du substrat d'alumine 12 dans le boîtier 16 par un film 22 tramé conducteur électrique préimpreigné de colle conductrice, puis polymérisation à chaud de la colle rendant le substrat en alumine 12 solidaire du boîtier 16.
- collage du substrat ferrite 14 avec de la colle conductrice 24 dans le fond du boîtier 16, le substrat ferrite 14 étant positionné préalablement à la main à l'intérieur de l'évidement 30 du substrat en alumine 12.

Le positionnement du substrat ferrite 14 dans le boîtier 16, à l'intérieur du passage 30 du substrat en alumine, est effectué en utilisant trois rondins de calibration (non représentés à la figure 1) placés entre le substrat ferrite 14 et le fond du boîtier 16, d'une part afin d'éviter la remontée de colle dans un interstice 26 apparaissant entre le substrat ferrite 14 et le substrat d'alumine 12 et d'autre part pour mettre au même niveau le substrat ferrite 14 et le substrat en alumine 12.
- réalisation des interconnexions électriques entre les métallisations 18 du substrat en alumine 12 et les métallisations 20 du substrat ferrite 14 par microcâblage de fils 32 en or d'un diamètre d'environ 25 micromètres. Le microcâblage des fils 32 est réalisé par ultrasons, thermo-compression ou soudure électrique.

Un petit aimant permanent, non représente sur la figure 1, est disposé sur le substrat ferrite d'une façon connue afin de réaliser la fonction d'isolateur ou de circulateur nécessaire au fonctionnement du module microélectronique de la figure 1.

Le module micro-électronique peut être plus complexe que celui représenté en exemple à la figure 1 pouvant comporter plusieurs substrats ferrites. En général, dans les modules micro-électroniques actuels, on trouve un substrat d'alumine et 3 à 5 substrats ferrites.

La fabrication des modules micro-électroniques hyperfréquences selon l'art antérieur comporte deux opérations de sérigraphie séparées pour la réalisation des métallisations des substrats en matériaux différents et implique un microcâblage filaire des interconnexions électriques entre ces substrats, long et délicat et par conséquent coûteux.

La présente invention permet de résoudre le double problème de sérigraphie séparée des substrats en matériaux différents et d'interconnexion par microcâblage filaire entre les substrats en proposant un module micro-électronique hyperfréquences comportant un substrat porteur et un substrat ferrite séparés par un interstice, chaque substrat ayant une face métallisée, une première face métallisée du substrat porteur et une première face métallisée du substrat ferrite étant situées dans un même premier plan P1, les deux substrats étant situés d'un même coté de ce premier plan, le substrat ferrite étant fixé au substrat porteur par une matière située dans l'interstice et qui affleure dans le premier plan P1, le substrat porteur, le substrat ferrite et la matière, formant un substrat unique métallisé, la matière là où elle affleure dans le premier plan P1 étant recouverte par une métallisation assurant l'interconnexion électrique entre celles des faces métallisées du substrat porteur et du substrat ferrite qui sont situées dans le premier plan P1,
caractérisé en ce que le substrat porteur et le substrat ferrite sont de même épaisseur et comportent chacun une seconde face métallisée, respectivement une seconde face métallisée du substrat porteur et une seconde face métallisée du substrat ferrite, ces secondes faces métallisées étant situées dans un même second plan P2, et en ce que la matière située dans l'interstice et qui affleure dans le second plan P2 est recouverte par une métallisation située dans ce second plan P2 assurant l'interconnexion électrique entre celles des faces métallisées du substrat porteur et du substrat ferrite qui sont situées dans le second plan P2.

Dans les réalisations du module selon l'invention, la matière située dans l'interstice est une pâte de scellement diélectrique, par exemple un verre de scellement diélectrique. Cette pâte doit présenter un coefficient de dilatation K compatible, c'est-à-dire de valeur proche et de même signe, que les coefficients de dilatation K1 du substrat porteur et K2 du substrat ferrite, afin d'obtenir une fixation fiable du substrat ferrite au substrat porteur.

La présente invention proposé aussi un procédé de fabrication d'un tel module micro-électronique hyperfréquences selon l'invention, caractérisé en ce qu'il comporte au moins les étapes suivantes:
- réalisation du substrat porteur et du substrat ferrite.
(dans cette étape de fabrication le substrat porteur et le substrat ferrite ne sont pas encore métallisés)
- fixation du substrat ferrite au substrat porteur par une matière remplissant l'interstice entre le substrat porteur et le substrat ferrite formant un substrat unique, la premiere face du substrat porteur et la premiere face du substrat ferrite étant situées dans le même premier plan P1, les deux substrats étant situés d'un même coté du premier plan P1 ; -métallisation d'au moins la face du substrat unique située dans le premier plan P1.

La fabrication selon l'invention d'un substrat unique métallisé permet de supprimer au moins deux opérations importantes et coûteuse nécessaires dans les procédés de fabrication de l'art antérieur, le collage du substrat ferrite dans le boîtier du module et l'interconnexion par microcâblage filaire entre les métallisations des deux substrats.

En effet l'intégration dans le boîtier du module micro-électronique du substrat unique constitué par le substrat porteur le substrat ferrite et la matière de remplissage de l'interstice entre les deux substrats est réalisé en une seule opération contrairement au procédé de fabrication selon l'art antérieur qui nécessite comme décrit précédemment au moins deux opérations, une pour chacun des substrats, consistant en une première opération d'intégration dans le boîtier du substrat en alumine métallisé puis une seconde opération intégration dans le boîtier du substrat ferrite métallisé.

Un autre avantage du procédé de fabrication du module selon l'invention réside dans la seule opération de métallisation du substrat unique et la suppression du microcâblage filaire nécessaire dans la fabrication des modules selon l'art antérieur. En effet une seule opération de métallisation collective en couche épaisse du substrat unique permet de réaliser les métallisations du substrat porteur, du substrat ferrite fixé au substrat porteur et de la matière située dans l'interstice affleurant au niveau des faces du substrat unique, ce qui assure l'interconnexion électrique entre les métallisations du substrat porteur et celles du substrat ferrite.

D'autres caractéristiques et avantages de l'invention apparaîtront à la lecture de la description détaillée qui en est faite en référence aux dessins annexés dans lesquels :
- la figure 1 représente un module micro-électronique, déjà décrit, selon l'art antérieur.
- les figures 2a,2b,3a,3b des vues du substrat d'alumine et du substrat ferrite du module de la figure 1, selon l'art antérieur.
- la figure 4 représente un module micro-électronique selon l'invention.
- les figures 5a,5b,6a,6b, des vues du substrat en porteur et du substrat ferrite du module de la figure 4 selon l'invention.
- les figures 7a et 7b montrent un dispositif utilisé pour la fixation du substrat ferrite au substrat porteur.
- la figure 8 montre le substrat unique du module de la figure 4 selon l'invention.
- les figures 9a et 9b montrent le substrat unique métallisé du module de la figure 4 selon l'invention.

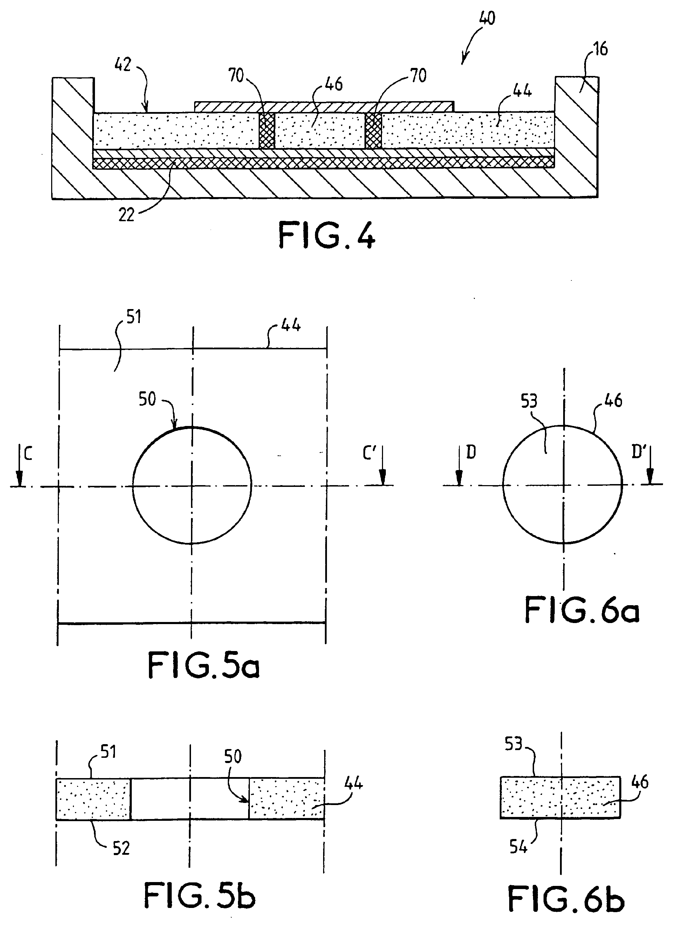

   La figure 4 représente un module électronique 40 selon l'invention comportant un substrat unique 42 métallisé sur ses deux faces et réalisé à partir d'un substrat porteur en alumine 44 et un substrat ferrite 46 intégré ou scellé au substrat porteur dans un évidement 50 circulaire réalisé dans le substrat porteur en alumine, le substrat porteur et le substrat ferrite ayant sensiblement la même épaisseur.
   Chaque substrat comporte une première face et une seconde face opposée à la première, respectivement une première face 51 et une seconde face 52 du substrat porteur et une première face 53 et une seconde face 54 du substrat ferrite.
   Le procédé de fabrication du module micro-électronique 40 comporte au moins les étapes de fabrication suivantes décrites en référence aux figures 4,5a,5b,6a,6b,7a,7b,8,9a et 9b.
- réalisation du substrat porteur en alumine 44 selon des techniques connues, comportant un passage 50 de forme circulaire permettant le scellement du substrat ferrite 46 dans le substrat porteur en alumine 44. Le passage 50 peut être réalisé par une découpe au laser CO2 du substrat porteur.

La figure 5a montre une vue partielle du substrat porteur et la figure 5b une coupe dans un plan perpendiculaire à la surface circulaire du substrat porteur selon un axe CC' montrant le passage 50.
- réalisation du substrat ferrite 46 en forme de pastille circulaire de diamètre sensiblement identique à celui du passage 50. Les tolérances de fabrications du passage 50 et du substrat ferrite 46 sont telles que ce dernier puisse être inséré dans le passage 50 sans difficulté. Par exemple dans cette réalisation les tolérances sur le diamètre de découpe du passage circulaire dans le substrat porteur sont de 0µm, +20µm et les tolérances sur le diamètre du substrat ferrite sont de 0µm, -20µm.

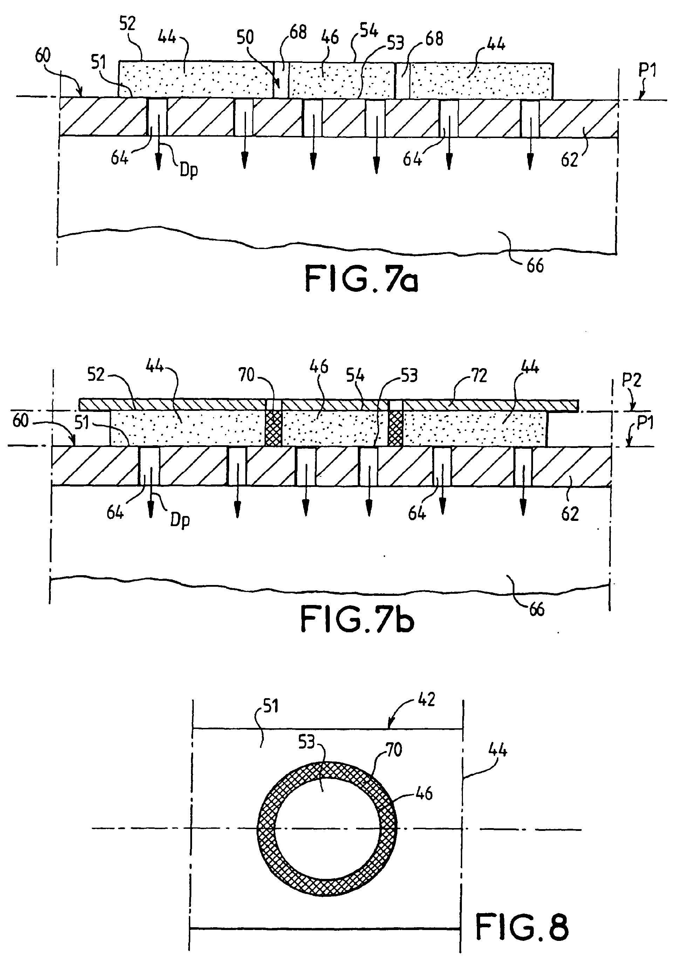

Les figures 6a et 6b montrent une vue du substrat ferrite 46 et une coupe dans un plan perpendiculaire à la surface circulaire du substrat ferrite selon un axe DD'.
- fixation du substrat ferrite 46 dans le substrat porteur 44 en alumine. A cet effet on utilise un dispositif 60 représenté aux figures 7a et 7b.

Le dispositif 60 comporte une plaque 62 ayant des trous d'aspiration 64 débouchant d'un côté de la plaque dans une enceinte 66 en dépression d'air Dp par rapport au milieu ambiant et de l'autre côté de la plaque, dans un premier plan P1, dans le milieu ambiant.

Le substrat porteur en alumine 44 est posé par sa première face 51 sur le premier plan P1, de l'autre côté de la plaque 62, à la pression ambiante, sur les trous d'aspiration 64. Le substrat porteur est maintenu appliqué contre la plaque par la dépression Dp à travers les trous 64.

Le substrat en ferrite 46 est placé en suite dans l'évidement 50 du substrat porteur, sa première face 53 étant appliquée contre la plaque 62 sur le premier plan P1. Le substrat ferrite se trouve à son tour maintenu en position contre la plaque par la dépression Dp à travers les trous 64

Les deux substrats ayant la même épaisseur, la seconde face 52 du substrat porteur et la seconde face 54 du substrat ferrite se trouvent situées sur un même second plan P2 représente à la figure 7b.

Un interstice 68 apparaît entre le substrat porteur en alumine 44 et le substrat ferrite 46 positionné dans l'évidement 50.

Une pâte de scellement 70 diélectrique, par exemple du verre de scellement, est alors déposée dans l'interstice 68 à l'aide d'un écran de sérigraphie 72

La pâte de scellement doit présenter un coefficient de dilatation K compatible avec le coefficient de dilatation K1 du substrat porteur et le coefficient de dilatation K2 du substrat ferrite.

Dans le cas de la réalisation du substrat unique 42 du module de la figure 4:
le coefficient de dilatation K de la pâte de scellement diélectrique est compris entre environ 7.10⁻⁶/°C et 8.10⁻⁶/°C,
le coefficient de dilatation K1 du substrat porteur en alumine (Al₂O₃) est d'environ 7.10⁻⁶/°C,
le coefficient de dilatation K2 du substrat ferrite est compris entre environ 6.10⁻⁶/°C et 7.10⁻⁶/°C,

Après séchage du verre de scellement, la fixation du substrat ferrite 46 au substrat porteur 44 par le verre de scellement diélectrique est obtenu, par une cuisson à environ une température de 850°C, formant le substrat unique 42.

Le substrat ferrite 46 devenant solidaire du substrat porteur 44, le substrat unique 42 pourra être métallisé.
- métallisation du substrat unique 42 selon les techniques connues en couche épaisse.

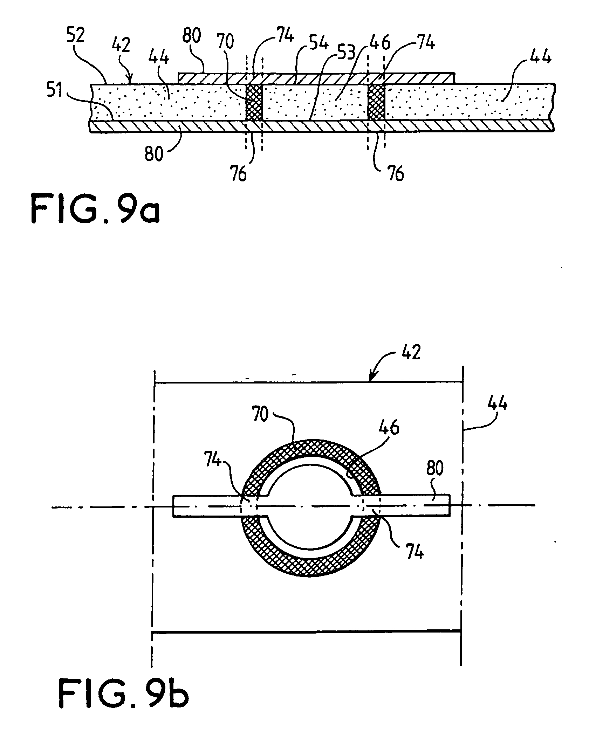

La figure 9a montre une coupe du substrat unique 42 après métallisation et la figure 9b une vue d'une de ses faces métallisée.

Des métallisations 80 sont déposées sur les deux faces du substrat unique 42 réalisant ainsi en une seule opération la métallisation du substrat porteur en alumine 44, du substrat ferrite 46 ainsi que les métallisations du verre de scellement 70 situées au niveau de l'interstice 68.

Les metallisations 80 du substrat unique comportent une première zone de métallisation 76 situé sur une des faces du substrat unique, assurant l'interconnexion électrique entre les métallisations des premières faces 51,53 des deux substrats et une seconde zone de metallisation 74 située sur l'autre face du substrat unique assurant l'interconnexion électrique entre les métallisations des secondes faces 52,54 des deux mêmes substrats.
- fixation du substrat unique métallisé selon des méthodes connues dans le boîtier 16, par exemple par collage par un film tramé conducteur électrique préimpregné de colle conductrice.

La métallisation collective du substrat unique en évitant l'interconnexion filaire de 25 micromètres, assure une meilleure reproductibilité des performances hyperfréquences du module ainsi réalisé.

On obtient également un gain industriel sur le coût de réalisation du module par la diminution du coût liée à la fabrication du substrat unique et la simplification de son montage dans le boîtier du module. Le cycle de fabrication du module peut être baissé d'au moins une heure grâce à la suppression de l'opération manuelle de montage du substrat ferrite dans le boîtier et la suppression du câblage filaire des modules de l'art antérieur.

La réalisation du module micro-électronique montrée en exemple dans la figure 4 n'est pas limitative. Des modules plus complexes utilisant un substrat porteur et plusieurs substrats ferrite scellés dans le substrat porteur selon l'invention, afin de réaliser des circulateurs ou des isolateurs hyperfréquences peuvent intégrer des éléments passifs réalisés par des techniques en couches épaisses, par exemple des résistances sérigraphiées à partir d'une pâte en dioxyde de Rhutenium, mais aussi des puces et des circuits intégrés reportés sur le substrat selon les techniques connues.

La réalisation des modules micro-électroniques selon l'invention assure une meilleur stabilité des performances hyperfréquences du module et une très bonne tenue aux variation rapides en température qui peut être comprise entre environ -55°C et +125°C.

## Revendications

1. Module micro-électronique hyperfréquences comportant un substrat porteur (12,44) et un substrat ferrite (14,46) séparés par un interstice (26,68), chaque substrat ayant une face métallisée, une première face (51) métallisée du substrat porteur et une première face (53) métallisée du substrat ferrite étant situées dans un même premier plan (P1), les deux substrats étant situés d'un même coté de ce premier plan, le substrat ferrite étant (46) fixé au substrat porteur (44) par une matière (70) située dans l'interstice (68) et qui affleure dans le premier plan (P1), , la matière là où elle affleure dans le premier plan (P1) étant recouverte par une métallisation (76) assurant l'interconnexion électrique entre celles (80) des faces métallisées du substrat porteur et du substrat ferrite qui sont situées dans le premier plan (P1) le substrat porteur, le substrat ferrite et la matière, formant un substrat unique (42) métallisé
**caractérisé en ce que** le substrat porteur (12,44) et le substrat ferrite (14,46) sont de même épaisseur et comportent chacun une seconde face métallisée, respectivement une seconde face métallisée (52) du substrat porteur et une seconde face métallisée (54) du substrat ferrite, ces secondes faces métallisées étant situées dans un même second plan (P2), et **en ce que** la matière (70) située dans l'interstice (68) et qui affleure dans le second plan (P2) est recouverte par une métallisation (74) située dans ce second plan assurant l'interconnexion électrique entre celles (80) des faces métallisées du substrat porteur et du substrat ferrite qui sont situées dans le second plan (P2).

2. Module micro-électronique hyperfréquences selon la revendication 1, **caractérisé en ce que** le substrat porteur (12,44) est un substrat en alumine.

3. Module micro-électronique hyperfréquences selon l'une des revendications 1 à 2, **caractérisé en** en ce que la matière (70) est une pâte de scellement présentant un coefficient de dilatation K compatible avec le coefficient de dilatation K1 du substrat porteur et le coefficient de dilatation K2 du substrat ferrite.

4. Module micro-électronique hyperfréquences selon la revendication 3, **caractérisé en** en ce que :
le coefficient de dilatation K de la pâte de scellement diélectrique est compris entre environ 7.10⁻⁶/°C et 8.10⁻⁶/°C,
que le coefficient de dilatation K1 du substrat portreur en alumine (Al₂O₃) est d'environ 7.10⁻⁶/°C,
et en ce que le coefficient de dilatation K2 du substrat ferrite est compris entre environ 6.10⁻⁶/°C et 7.10⁻⁶/°C.

5. Module micro-électronique hyperfréquences selon l'une des revendications 2 a 4, **caractérisé en** en ce que le substrat porteur en alumine (44) comporte un passage (50) de forme circulaire permettant le scellement d'un substrat ferrite (46) dans le substrat porteur en alumine (44), le substrat ferrite étant en forme de pastille circulaire de diamètre sensiblement identique à celui du passage (50).

6. Procédé de fabrication d'un module micro-électronique hyperfréquences selon l'une quelconque des revendications précédentes, **caractérisé en ce qu'**il comporte au moins les étapes suivantes:
- réalisation du substrat porteur (44) et du substrat ferrite (46), non métallisés.
- fixation du substrat ferrite (46) au substrat porteur (44) par une matière (70) remplissant l'interstice (68) entre le substrat porteur et le substrat ferrite, formant un substrat unique (42), la première face (51) du substrat porteur et la première face (53) du substrat ferrite étant situées dans le même premier plan (P1), les deux substrats étant situés d'un même coté du premier plan (P1).
- métallisation d'au moins la face du substrat unique située dans le premier plan.

7. Procédé de fabrication d'un module micro-électronique hyperfréquences selon la revendication 6 **caractérisée en ce que** matière (70) remplissant l'interstice (68) entre le substrat porteur et le substrat ferrite est une pâte diélectrique et **en ce que** le remplissage de l'interstice (68) est effectué l'aide un écran de sérigraphie (72).

8. Procédé de fabrication d'un module micro-électronique hyperfréquences selon la revendication 7 **caractérisée en ce que** la pâte est un verre de scellement diélectrique.

9. Procédé de fabrication d'un module micro-électronique hyperfréquences selon la revendication 8, **caractérisée en ce que**, après séchage du verre de sceilement, la fixation du substrat ferrite (46) au substrat porteur (44) par le verre de scellement diélectrique est obtenu, par une cuisson à environ une température de 850°C, formant le substrat unique (42).

10. Procédé de fabrication d'un module micro-électronique hyperfréquences selon l'une des revendications 6 à 9, **caractérisée en ce que** la métallisation (80) du substrat unique est effectuée selon la technologie de couche épaisse.

11. Procédé de fabrication d'un module micro-électronique hyperfréquences selon l'une des revendications 6 a 10, **caractérisée en ce que** le passage (50) de forme circulaire permettant le scellement du substrat ferrite (46) dans le substrat porteur en alumine (44) est réalisé par une découpe au laser CO2 du substrat porteur en alumine.

## Claims

1. Microwave microelectronic module comprising a carrier substrate (12, 44) and a ferrite substrate (14, 46) that are separated by a gap (26, 68), each substrate having a metallized face, a first metallized face (51) of the carrier substrate and a first metallized face (53) of the ferrite substrate both lying in one and the same first plane (P1), the two substrates lying on one and the same side of this first plane, the ferrite substrate (46) being fastened to the carrier substrate (44) by a material (70) which is located in the gap (68) and is flush with the first plane (P1), the material where it is flush with the first plane (P1) being covered by a metallization (76) for ensuring electrical interconnection between those (80) of the metallized faces of the carrier substrate and of the ferrite substrate which lie in the first plane (P1), the carrier substrate, the ferrite substrate and the material together forming a single metallized substrate (42),
**characterized in that** the carrier substrate (12, 44) and the ferrite substrate (14, 46) have the same width and each include a second metallized face, namely a second metallized face (52) of the carrier substrate and a second metallized face (54) of the ferrite substrate respectively, these second metallized faces lying in one and the same second plane (P2), and **in that** the material (70) which is located in the gap (68) and is flush with the second plane (P2) is covered by a metallization (74) lying in this second plane, ensuring electrical interconnection between those (80) of the metallized faces of the carrier substrate and of the ferrite substrate that lie in the second plane (P2) .

2. Microwave microelectronic module according to Claim 1, **characterized in that** the carrier substrate (12, 44) is an alumina substrate.

3. Microwave microelectronic module according to either of Claims 1 or 2, **characterized in that** the material (70) is a sealing paste having an expansion coefficient K compatible with the expansion coefficient K1 of the carrier substrate and the expansion coefficient K2 of the ferrite substrate.

4. Microwave microelectronic module according to Claim 3, **characterized in that**:
- the expansion efficient K of the dielectric sealing paste is between about 7 × 10⁻⁶/°C and 8 × 10⁻⁶/°C;
- **in that** the expansion coefficient K1 of the alumina (Al₂O₃) carrier substrate is about 7 × 10⁻⁶/°C;
- and **in that** the expansion coefficient K2 of the ferrite substrate is between about 6 × 10⁻⁶/°C and 7 × 10⁻⁶/°C.

5. Microwave microelectronic module according to one of Claims 2 to 4, **characterized in that** the alumina carrier substrate (44) includes a passage (50) of circular shape for sealing a ferrite substrate (46) into the alumina carrier substrate (44), the ferrite substrate being in the form of a circular disc with a diameter substantially identical to that of the passage (50).

6. Process for manufacturing a microwave microelectronic module according to any one of the preceding claims, **characterized in that** it comprises at least the following steps:
- production of the carrier substrate (44) and the ferrite substrate (46), these not being metallized;
- fastening of the ferrite substrate (46) to the carrier substrate (44) by a material (70) that fills the gap (68) between the carrier substrate and the ferrite substrate, together forming a single substrate (42), the first face (51) of the carrier substrate and the first face (53) of the ferrite substrate both lying in one and the same first plane (P1), the two substrates being located on one and the same side of the first plane (P1) ; and
- metallization of at least that face of the single substrate which lies in the first plane.

7. Process for manufacturing a microwave microelectronic module according to Claim 6, **characterized in that** the material (70) filling the gap (68) between the carrier substrate and the ferrite substrate is a dielectric paste and **in that** the filling of the gap (68) is carried out with the aid of a screen-printing screen (72).

8. Process for manufacturing a microwave microelectronic module according to Claim 7, **characterized in that** the paste is a dielectric sealing glass.

9. Process for manufacturing a microwave microelectronic module according to Claim 8, **characterized in that**, after the sealing glass has dried, the fastening of the ferrite substrate (46) to the carrier substrate (44) by the dielectric sealing glass is achieved by a baking operation at a temperature of about 850°C, forming the single substrate (42).

10. Process for manufacturing a microwave microelectronic module according to one of Claims 6 to 9, **characterized in that** the metallization (80) of the single substrate is carried out using thick film technology.

11. Process for manufacturing a microwave microelectronic module according to one of Claims 6 to 10, **characterized in that** the passage (50) of circular shape for sealing the ferrite substrate (46) into the alumina carrier substrate (44) is produced by cutting the alumina carrier substrate with a CO₂ laser.

## Patentansprüche

1. Mikroelektronisches Hyperfrequenzmodul mit einem Trägersubstrat (12, 44) und einem Ferritsubstrat (14, 46), die durch einen Zwischenraum (26, 68) getrennt sind, wobei jedes Substrat eine metallisierte Fläche hat, wobei eine erste metallisierte Fläche (51) des Trägersubstrats und eine erste metallisierte Fläche (53) des Ferritsubstrats sich in einer gleichen ersten Ebene (P1) befinden, wobei die zwei Substrate sich auf der gleichen Seite von dieser ersten Ebene befinden, wobei das Ferritsubstrat (46) durch einen Stoff (70), der sich im Zwischenraum (68) befindet und der bündig auf der ersten Ebene (P1) anliegt, auf dem Trägersubstrat (44) befestigt ist, der Stoff, dort, wo er bündig auf der ersten Ebene (P1) anliegt, mit einer Metallisierung (76) bedeckt ist, die eine elektrische Zusammenschaltung zwischen denjenigen (80) metallisierten Flächen des Trägersubstrats und des Ferritsubstrats sichert, die sich in der ersten Ebene (P1) befinden, wobei das Trägersubstrat, das Ferritsubstrat und der Stoff ein einziges metallisiertes Substrat (42) bilden,
**dadurch gekennzeichnet, dass** das Trägersubstrat (12, 44) und das Ferritsubstrat (14, 46) von gleicher Dicke sind und jeweils eine zweite metallisierte Fläche, eine zweite metallisierte Fläche (52) des Trägersubstrats beziehungsweise eine zweite metallisierte Fläche (54) des Ferritsubstrats, aufweisen, wobei diese zweiten metallisierten Flächen sich auf einer gleichen zweiten Ebene (P2) befinden, **dadurch**, dass der Stoff (70), der sich im Zwischenraum (68) befindet und der bündig auf der zweiten Ebene (P2) anliegt, mit einer Metallisierung (74) bedeckt ist, die sich in dieser zweiten Ebene befindet und die die elektrische Zusammenschaltung zwischen denjenigen metallisierten Flächen (80) des Trägersubstrats und des Ferritsubstrats, die sich in der zweiten Ebene (P2) befinden, sichert.

2. Mikroelektronisches Hyperfrequenzmodul nach Anspruch 1, **dadurch gekennzeichnet, dass** das Trägersubstrat (12, 44) ein Substrat aus Aluminiumoxid ist.

3. Mikroelektronisches Hyperfrequenzmodul nach einem der Ansprüche 1 bis 2, **dadurch gekennzeichnet, dass** der Stoff (70) eine Vergussmasse ist, die einen Ausdehnungskoeffizienten K aufweist, der mit dem Ausdehnungskoeffizienten K1 des Trägersubstrats und dem Ausdehnungskoeffizienten K2 des Ferritsubstrats verträglich ist.

4. Mikroelektronisches Hyperfrequenzmodul nach Anspruch 3, **dadurch gekennzeichnet, dass**:
der Ausdehnungskoeffizient K der dielektrischen Vergussmasse zwischen 7.10⁻⁶/°C und 8.10⁻⁶/°C enthalten ist,
der Ausdehnungskoeffizient K1 des Trägersubstrats aus Aluminiumoxid (Al₂O₃) ungefähr 7.10⁻⁶/°C beträgt,
und, dass der Ausdehnungskoeffizient K2 des Ferritsubstrats zwischen ungefähr 6.10⁻⁶/°C und 7.10⁻⁶/°C enthalten ist.

5. Mikroelektronisches Hyperfrequenzmodul nach einem der Ansprüche 2 bis 4, **dadurch gekennzeichnet, dass** das Trägersubstrat aus Aluminiumoxid (44) einen kreisförmigen Durchlass (50) aufweist, der den Verguss eines Ferritsubstrats (46) im Trägersubstrat aus Aluminiumoxid (44) ermöglicht, wobei das Ferritsubstrat in der Form einer kreisförmigen Pille ist, deren Durchmesser im Wesentlichen mit demjenigen des Durchlasses (50) identisch ist.

6. Herstellungsverfahren eines mikroelektronischen Hyperfrequenzmoduls nach einem der vorhergehenden Ansprüche, **dadurch gekennzeichnet, dass** es mindestens die folgenden Schritte aufweist:
- nicht metallisierte Verwirklichung des Trägersubstrats (44) und des Ferritsubstrats (46).
- Befestigung des Ferritsubstrats (46) am Trägersubstrat (44) durch einen Stoff (70), der den Zwischenraum (68) zwischen dem Trägersubstrat und dem Ferritsubstrat ausfüllt, wodurch ein einziges Substrat (42) gebildet wird, wobei die erste Fläche (51) des Trägersubstrats und die erste Fläche (53) des Ferritsubstrats sich in der gleichen Ebene (P1) befinden, wobei die zwei Substrate sich auf einer gleichen Seite der ersten Ebene (P1) befinden.
- Metallisierung von mindestens der Fläche des einzigen Substrats, die sich in der ersten Ebene befindet.

7. Herstellungsverfahren eines mikroelektronischen Hyperfrequenzmoduls nach Anspruch 6, **dadurch gekennzeichnet, dass** der Stoff (70), der den Zwischenraum (68) zwischen dem Trägersubstrat und dem Ferritsubstrat ausfüllt, eine dielektrische Masse ist und, dass das Ausfüllen des Zwischenraums (68) mit Hilfe einer Siebdruckschablone (72) ausgeführt wird.

8. Herstellungsverfahren eines mikroelektronischen Hyperfrequenzmoduls nach Anspruch 7, **dadurch gekennzeichnet, dass** die Masse ein dielektrisches Glaslot ist.

9. Herstellungsverfahren eines mikroelektronischen Hyperfrequenzmoduls nach Anspruch 8, **dadurch gekennzeichnet, dass** nach dem Trocknen des Glaslots die Befestigung des Ferritsubstrats (46) am Trägersubstrat (44) durch das dielektrische Glaslot durch ein Brennen bei einer Temperatur von ungefähr 850°C erreicht wird, wodurch das einzige Substrat (42) gebildet wird.

10. Herstellungsverfahren eines mikroelektronischen Hyperfrequenzmoduls nach einem der Ansprüche 6 bis 9, **dadurch gekennzeichnet, dass** die Metallisierung (80) des einzigen Substrats mit der Dickschichttechnologie ausgeführt wird.

11. Herstellungsverfahren eines mikroelektronischen Hyperfrequenzmoduls nach einem der Ansprüche 6 bis 10, **dadurch gekennzeichnet, dass** der kreisförmige Durchlass (50), der den Verguss des Ferritsubstrats (46) im Trägersubstrat aus Aluminiumoxid (44) ermöglicht, durch CO2-Laserschnitt des Trägersubstrats aus Aluminiumoxid verwirklicht wird.
